# EUROPEAN PATENT SPECIFICATION

(11) **EP 1 061 788 B1**
(45) Date of publication and mention of the grant of the patent: **28.01.2004**
(21) Application number: 00440165.9
(22) Date of filing: 30.05.2000
(51) Int. Cl.: H05K 7/20, H02B 1/56

(54) **Ducted cooling equipment housing**
Gehäuse einer Anlage mit Kühlluftführung
Boîtier d'équipement avec conduit de refroidissement

(30) Priority: 16.06.1999 AU PP749899; 08.05.2000 AU 3531400
(43) Date of publication of application: 20.12.2000
(73) Proprietor: ALCATEL, 75008 Paris (FR)
(72) Inventor: Mowat, Scott, Bondi Junction, New South Wales 2022 (AU); Counsell, Matthew Charles, New South Wales 2112 (AU); Buchanan, Michael, New South Wales 2159 (AU)
(74) Representative: Rausch, Gabriele, Dr.

(56) References cited:
- DE-A- 2 231 469
- DE-A- 2 622 470
- DE-A- 2 744 664
- DE-A- 2 844 672
- DE-A- 3 717 540
- GB-A- 2 277 767

## Description

The present invention relates to an equipment housing arrangement including an outdoor housing substantially sealed to the environment, at least one heat exchange means, an exterior section of which is outside the housing, and an interior section of which is inside the housing, at least one equipment racks assembly connected to form a closed air circulation path with the interior section of a corresponding one of the heat exchange means, and first air impeller means to circulate air around the closed air circulation path.

Such an equipment housing arrangement is known from the document DE 27 44 664 as well as from the document DE 37 17 540.

This invention relates, in general, to arrangements for cooling equipment housings, and is adapted for use with electronic or telecommunication equipment housings exposed to an outdoor environment.

Generally such equipment generates waste heat which must be removed to prevent overheating. Removing the waste heat is made more difficult because the housing must be sealed against the external environment to prevent rain and dust etc. from damaging the equipment.

In a known housing, the equipment is housed in a double skin housing. The inner shell is sealed while the outer shell includes convection cooling vents. A fan forced heat exchanger transfers heat from the sealed inner shell. Such a housing is known from DE 196 23 677 as well as from DE 295 19 260 U.

One problem with this arrangement is that the inner and outer shells have large surfaces which are unsupported. The air from the fan causes these surfaces to reverberate. The fans themselves are another source of noise. The noise from such an arrangement may exceed permissible environmental noise limits e.g. 38 dBa in day light/30 dBa at night. In view of the above prior art, it is an objective of the present invention to provide for an equipment housing arrangement which produces less noise than known equipment housings, and, further, which improves isolation of the equipment from the solar heating effect.

This objective is achieved by an equipment housing arrangement as mentioned at the outset, the equipment housing arrangement further including a plurality of equipment racks enclosed in cowlings to form a column of ducted equipment racks through which air can be circulated by fans as first air impeller means.

In a further embodiment, the arrangement includes second air impeller means to force air across the exterior section of the heat exchanger means.

In another embodiment the exterior section of the heat exchange means is housed in an exterior duct having input and output vents.

In a preferred embodiment the direction of the output of the second air impeller is substantially transverse to the direction of flow through the output vent.

In a still further embodiment, an acoustic baffle is provided at the output vent.

In yet another embodiment, the fans are run at above normal speed to increase the cooling effect, the noise abatement means ensuring that the fan noise does not exceed the permitted noise levels.
- Figure 1: is a representation of an equipment housing embodying the invention.
- Figure 2: is an exploded partial view of the internal equipment ducting and heat exchanger.
- Figure 3: is a schematic view of equipment embodying the invention.
- Figure 4: shows a second housing arrangement according to a further embodiment of the invention.

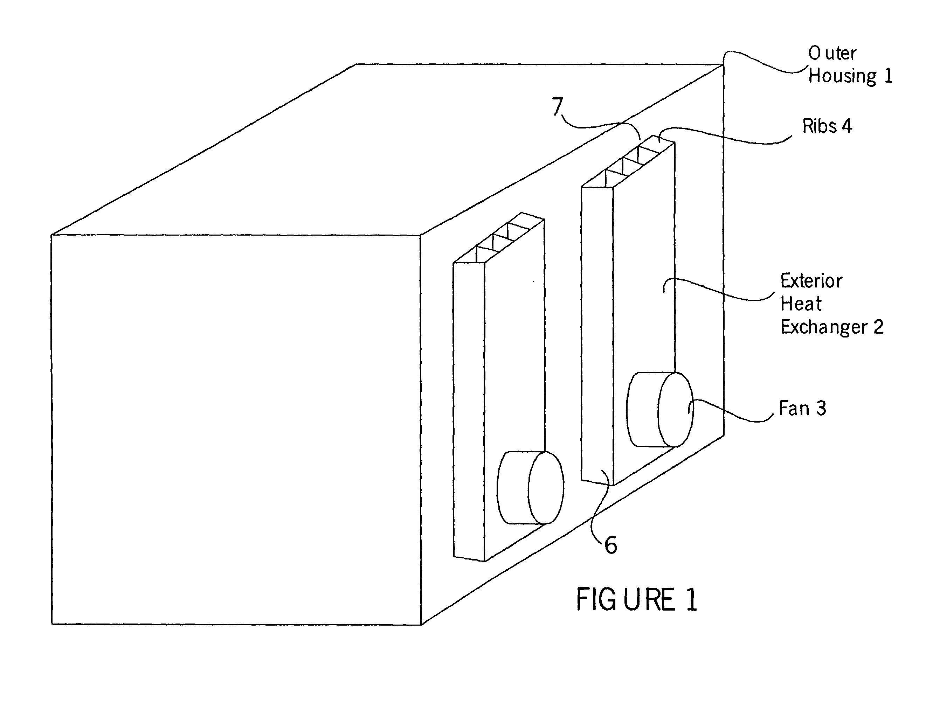

The invention will be described with reference to the accompanying drawings. Figure 1 is an external view of a sealed housing 1. The housing has a sealed door (not shown) to provide access to the equipment. A pair of exterior heat exchanger elements 2 are affixed to a wall of the housing 1. The heat exchangers include cooling fins or ribs 4. Optionally the fins are enclosed by a cowling arrangement. A fan 3 may also be provided to blow air through the cowling to remove heat from the fins.

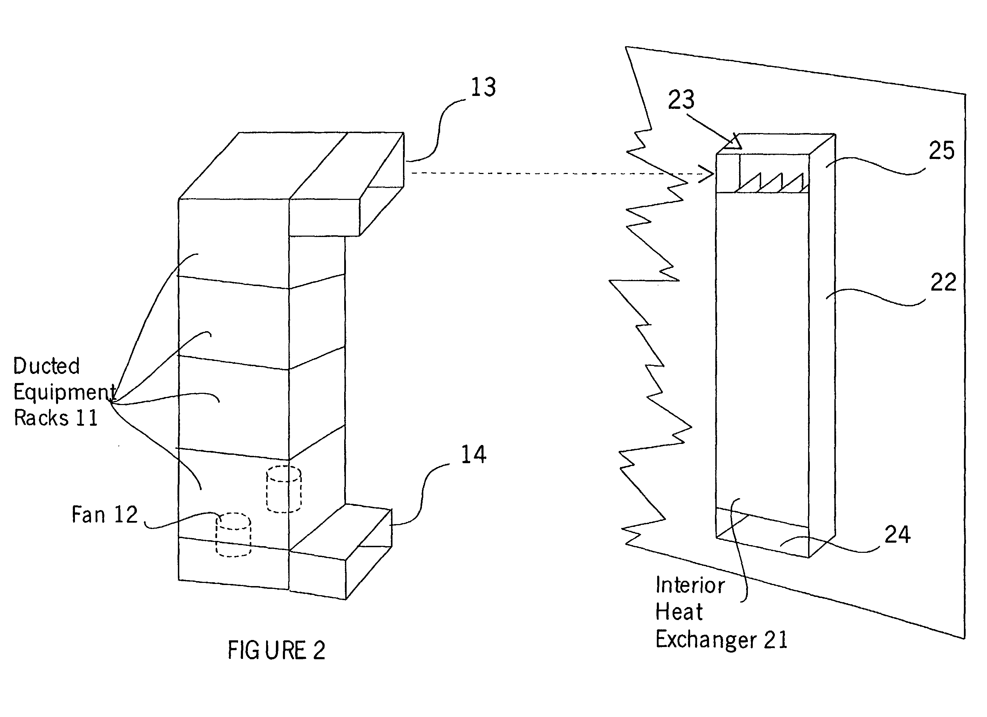

Figure 2 shows a partly exploded view of a plurality of equipment racks enclosed in cowlings to form a column of ducted equipment racks 11 through which air can be circulated by Fans 12.

Extensions 13 and 14 of the equipment ducting are arranged to interface with an interior heat exchanger element 21 having a plurality of fins or ribs 25 enclosed in ducting 22 and having openings 23 and 24 to interface with the ducting extensions 13 and 14 respectively. The equipment in each equipment rack may include a plurality of circuit boards arranged in spaced apart parallel vertical planes.

Thus the air from the fans can pass over the surface of the circuit boards to remove heat from the circuit boards. The heated air then passes through extension 13 to interior heat exchanger 21 via vent 23 where the heat is transferred to the Fins 25. The air is then circulated back to the intake of the Fans 12 via opening 24 and extension 14.

The interior heat exchanger element 21 is aligned with a corresponding exterior heat exchanger element 2 shown in Figure 1. Thus the heat from Fins 25 of the interior heat exchanger is transferred to the fins 4 of the exterior heat exchanger 4 by conduction through the walls of the housing 1.

The fins 4 may be cooled by natural convection. In a preferred embodiment, the fins 4 are enclosed in a cowling 6, and cooled by Fan 3.

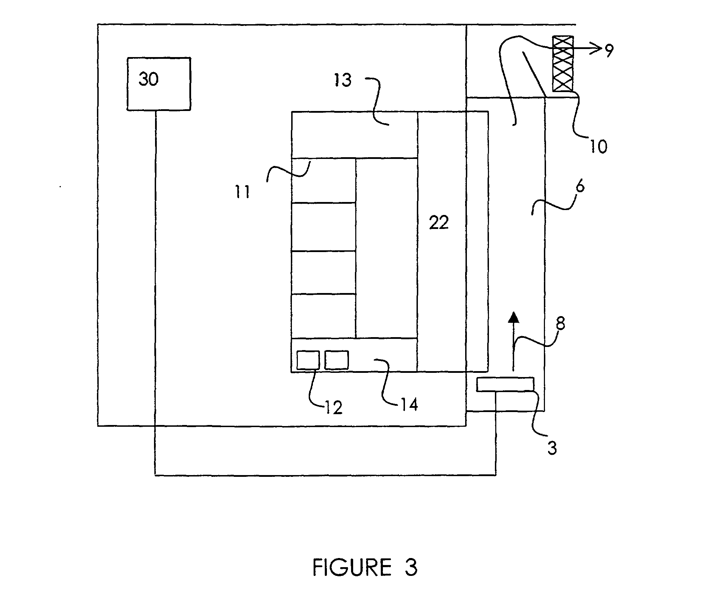

Preferably, an acoustic baffle 10, Figure 3 is fitted to the output vent 7 of the exterior heat exchanger.

The direction of the output 8 from the fan 3 is preferably directed transverse to the output 9 from vent 7 to reduce the noise radiated in the direction 9.

As shown in figure 3, the thermostat 30 located in the equipment housing, preferably in the equipment ducting, is used to switch off the exterior fan 3 when the equipment temperature is below a predetermined threshold. This condition will generally prevail at nighttime as the solar heating load of about 1200w/m2 is removed (-1600 w total). The equipment in each column may, for example, generate 300w, so the demands on the system are lessened, and unforced convection may be adequate to cool the exterior part of the heat exchanger. With the exterior fan turned off, the equipment can satisfy the stricter nighttime noise limit.

Because the equipment cowling has a much smaller unsupported span than the inner shell of the prior art, there is less secondary noise generated by reverberation.

Another advantage of the present invention is that the air between the outer housing and the equipment cowling is static because the outer housing is not vented. This static air forms a thermal insulator to partially isolate the equipment from the solar heating effect.

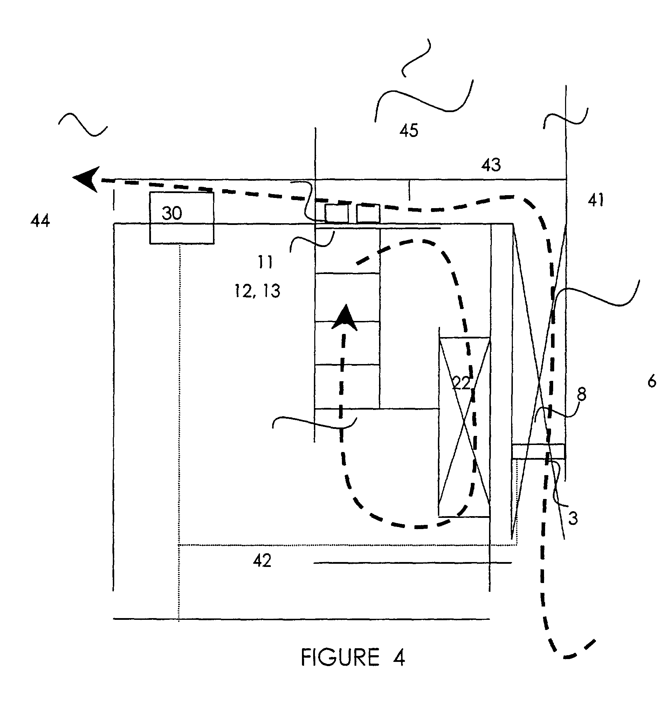

In a preferred embodiment, shown in figure 4, the roof of the cabinet serves as the top of the equipment ducting. The air blown over the equipment is then blown against the roof of the cabinet. This air is at the highest temperature as it has just been blown over the equipment. To reduce the solar heating load on the roof of the cabinet, the roof is designed as a double layer with an air cavity between the upper and lower levels. The cavity is vented to the atmosphere.

To improve the cooling efficiency, the air from the external heat exchanger section is ducted into the roof cavity. Effectively, the inner roof layer becomes a part of the heat exchanger.

In Figure 4, the top of the equipment ducting is formed by part of the inner roof layer indicated at 43. The outer heat exchanger ducting is connected to the outer roof layer instead of being vented to the atmosphere. This makes the cavity between the inner and outer roof layers effectively part of the outer heat exchanger cooling air path 41. Thus fan 3 forces air over the external heat exchanger fins and this air is then forced into the roof cavity and vented through venting slots 44. One or more transverse baffles 45 may depend from the outer layer into the cavity to cause the flow to be biased towards the inner layer.

Preferably the fans 12, 13 are placed above the equipment racks so their output is directed against the region 40 of the inner roof layer. Thus the hottest air is blown against the roof. The turbulence created by the forced air discharge against region 43 may facilitate the transfer of heat from the air to the inner layer in the inner heat exchange air flow circuit 42.

The outer heat exchange air flow path 41 extracts heat from the outer exchanger fins so the hottest air leaves the top of the exchanger fins and then passes over the region 43.

## Claims

1. An equipment housing arrangement including:
- an outer housing (1) substantially sealed to the environment,
- at least one heat exchange means (2, 21), an exterior section of which is outside the housing, and an interior section of which is inside the housing;
- at least one equipment racks assembly (11) connected to form a closed air circulation path with the interior section of a corresponding one of the heat exchange means;
- and first air impeller means to circulate air around the closed air circulation path;
**characterized by** a plurality of equipment racks enclosed in cowlings to form a column of ducted equipment racks (11) through which air can be circulated by fans (12) as said first air impeller means.

2. An arrangement as claimed in claim 1, wherein static air between the outer housing and the ducted equipment assembly provides thermal insulation from the exterior environment.

3. An arrangement as claimed in claim 1, wherein the housing includes a cavity roof formed by an inner layer and an outer layer.

4. An arrangement as claimed in claim 3 wherein the exterior section of the heat exchanger is housed in ducting and the ducting opens into the roof cavity.

5. An arrangement as claimed in claim 4, wherein the inner air is discharged against a section of the inner roof layer by the first air impeller means.

6. An arrangement as claimed in any one of claims 3 to 5 including one or more baffles depending from the outer layer.

7. An arrangement as claimed in any one of claims 1 to 4 including second air impeller means to force air across the exterior section of the heat exchange means.

8. An arrangement as claimed in any one of claims 1 to 3, wherein the exterior section of the heat exchange means is housed in an exterior duct having input and output vents.

9. An arrangement as claimed in claim 8, wherein the output of the second air impeller means is substantially transverse to the direction of flow through the output vent.

10. An arrangement as claimed in claim 8 or claim 9 including an acoustic baffle across the output vent.

11. An arrangement as claimed in any one of claims 1 to 10, wherein the fans are run at above rating speed to increase air flow, the noise reduction measures ensuring the noise remains within limits.

12. An arrangement as claimed in claim 5 or any one of claims 3 to 6 as appended to claim 2, including temperature sensing means to measure the temperature of the equipment and switch off the second air impeller means when the temperature falls below a pre-determined threshold.

## Patentansprüche

1. Eine Anlagen-Gehäuse-Anordnung, die folgendes enthält:
- Ein äußeres Gehäuse (1), dass im Wesentlichen gegen die Umgebung abgedichtet ist.
- Mindestens ein Wärmetauscher-Mittel (2,21), von dem ein äußerer Teil sich außerhalb des Gehäuses und ein innerer Teil sich innerhalb des Gehäuses befindet;
- Mindestens eine Anlagen-Gestell-Baugruppe (11), die so angeschlossen ist, dass sie einen geschlossenen Luftzirkulations-Pfad mit dem inneren Teil eines entsprechenden der Wärmetauscher-Mittel bildet;
- und erste Luft-Flügelrad-Mittel zur Zirkulation von Luft in dem geschlossenen Luft-Zirkulations-Pfad;
**gekennzeichnet durch** eine Vielzahl von Anlagen-Gestellen, die sich in Verkleidungen befinden, um eine Säule von Anlagen-Gestellen mit Kühlluftführung (11) zu bilden, **durch** die Luft mit Ventilatoren (12) als erste Luft-Flügelrad-Mittel geleitet werden kann.

2. Eine Anordnung, wie in Anspruch 1 beansprucht, worin stehende Luft zwischen dem äußeren Gehäuse und der Anlagen-Baugruppe mit Kühlluftführung eine thermische Isolation gegen die äußere Umgebung bietet.

3. Eine Anordnung, wie in Anspruch 1 beansprucht, worin das Gehäuse ein Dach mit Hohlraum enthält, der durch eine innere Schicht und eine äußere Schicht gebildet wird.

4. Eine Anordnung, wie in Anspruch 3 beansprucht, worin der äußere Teil des Wärmetauschers sich in der Kühlluftführung befindet und die Kühlluftführung sich in den Hohlraum des Dachs öffnet.

5. Eine Anordnung, wie in Anspruch 4 beansprucht, worin die innere Luft von den ersten Luft-Flügelrad-Mitteln gegen einen Abschnitt der inneren Schicht des Dachs ausgelassen wird.

6. Eine Anordnung, wie in einem beliebigen der Ansprüche 3 bis 5 beansprucht, die ein oder mehrere Ablenkplatten enthält, die von der äußeren Schicht herabhängen.

7. Eine Anordnung, wie in einem beliebigen der Ansprüche 1 bis 4 beansprucht, die zweite Luft-Flügelrad-Mittel enthält, um zwangsweise Luft über den äußeren Teil der Wärmetauscher-Mittel zu führen.

8. Eine Anordnung, wie in einem beliebigen der Ansprüche 1 bis 3 beansprucht, worin der äußere Teil der Wärmetauscher-Mittel sich in einer äußeren Kühlluftführung befindet, die Einlass- und Auslass-Lüftungsöffnungen hat.

9. Eine Anordnung, wie in Anspruch 8 beansprucht, worin der Auslass der zweiten Luft-Flügelrad-Mittel im Wesentlichen quer zur Richtung des Flusses durch die Auslass-Lüftungsöffnung ist.

10. Eine Anordnung, wie in Anspruch 8 oder Anspruch 9 beansprucht, die eine akustische Abschirmung über der Auslass-Lüftungsöffnung enthält.

11. Eine Anordnung, wie in einem beliebigen der Ansprüche 1 bis 10 beansprucht, worin die Ventilatoren über der Nenn-Drehzahl betrieben werden, um den Luftfluss zu erhöhen, wobei die Geräuschreduktions-Mittel sicherstellen, dass die Geräuschentwicklung innerhalb der Grenzwerte bleibt.

12. Eine Anordnung, wie in Anspruch 5 oder einem beliebigen der Ansprüche 3 bis 6 beansprucht, wie an Anspruch 2 angehängt, die ein Mittel zur Temperaturmessung enthält, um die Temperatur der Anlage zu messen und die zweiten Luft-Flügelrad-Mittel auszuschalten, wenn die Temperatur unter einen vorher festgelegten Schwellwert fällt.

## Revendications

1. Agencement de coffret d'appareillage, comprenant :
- un coffret extérieur (1) substantiellement hermétique à l'environnement ;
- au moins un moyen d'échange thermique (2, 21), dont une section extérieure se trouve à l'extérieur du coffret et dont une section intérieure se trouve à l'intérieur du coffret ;
- au moins un ensemble de bâtis électroniques (11) reliés pour former un circuit d'air fermé avec la section intérieure d'un moyen correspondant des moyens d'échange thermique ;
- et des premiers moyens de turbine d'air pour faire circuler l'air autour du circuit d'air fermé ;
**caractérisé par** une pluralité de bâtis électroniques enfermés dans des capots pour former une colonne de bâtis électroniques canalisés (11) à travers lesquels l'air peut être amené à circuler par des ventilateurs (12) comme lesdits premiers moyens de turbine d'air.

2. Agencement selon la revendication 1, dans lequel l'air statique entre le coffret extérieur et l'ensemble d'appareillage canalisé prévoit une isolation thermique contre l'environnement extérieur.

3. Agencement selon la revendication 1, dans lequel le coffret comprend un plafond de cavité formé par une couche intérieure et une couche extérieure.

4. Agencement selon la revendication 3, dans lequel la section extérieure de l'échangeur thermique est logée dans la canalisation et la canalisation s'ouvre sur la cavité de plafond.

5. Agencement selon la revendication 4, dans lequel l'air intérieur est déchargé contre une section de la couche de plafond intérieure par les premiers moyens de turbine d'air.

6. Agencement selon l'une quelconque des revendications 3 à 5, comprenant une ou plusieurs chicanes suspendues à partir de la couche extérieure.

7. Agencement selon l'une quelconque des revendications 1 à 4, comprenant des deuxièmes moyens de turbine d'air pour forcer l'air à travers la section extérieure des moyens d'échange thermique.

8. Agencement selon l'une quelconque des revendications 1 à 3, dans lequel la section extérieure des moyens d'échange thermique est logée dans une canalisation extérieure ayant des grilles d'entrée et de sortie.

9. Agencement selon la revendication 8, dans lequel la sortie des deuxièmes moyens de turbine d'air est substantiellement transversale à la direction d'écoulement à travers la grille de sortie.

10. Agencement selon la revendication 8 ou 9, comprenant une chicane acoustique à travers la grille de sortie.

11. Agencement selon l'une quelconque des revendications 1 à 10, dans lequel les ventilateurs sont exploités à une vitesse supérieure à la vitesse nominale pour augmenter le débit d'air, les moyens de réduction de bruit assurant que le bruit reste limité.

12. Agencement selon la revendication 5 ou l'une quelconque des revendications 3 à 6 dans la mesure où elles dépendent de la revendication 2, comprenant des moyens de détection de température pour mesurer la température de l'appareillage et couper les deuxièmes moyens de turbine d'air lorsque la température tombe au-dessous d'un seuil prédéterminé.
